Europäisches Patentamt

(19) European Patent Office (11) Veröffentlichungsnummer: **0 033 125**

Office européen des brevets **B1**

(12) **EUROPÄISCHE PATENTSCHRIFT**

(45) Veröffentlichungstag der Patentschrift:
29.06.83

(21) Anmeldenummer: **81100401.9**

(22) Anmeldetag: **21.01.81**

(51) Int. Cl.³: **H 03 K 3/037**

(54) **Schaltkreis für ein D-Flip-Flop.**

(30) Priorität: **24.01.80 JP 6355/80**

(43) Veröffentlichungstag der Anmeldung:
**05.08.81 Patentblatt 81/31**

(45) Bekanntmachung des Hinweises auf die Patenterteilung:
**29.06.83 Patentblatt 83/26**

(84) Benannte Vertragsstaaten:
**CH DE FR GB IT LI**

(56) Entgegenhaltungen:
**U. Tietze** *et al.* **„Halbleiter-Schaltungstechnik",
4. Auflage, 1978, Springer-Verlag Berlin, Heidelberg, New York, S. 164 und 165.**

(73) Patentinhaber: **YAMATAKE-HONEYWELL CO.LTD.,
2-12-19, Shibuya-Ku, Tokyo 150 (JP)**

(72) Erfinder: **Yamamoto, Yuji, 8-19 Higashi-Kaigan 2-chome,
Tsujido, Fujisawa-city Kanagawa (JP)**
Erfinder: **Shiragaki, Sei, 3552-15, Shimotsuruma,
Yamamoto-city Kanagawa (JP)**

(74) Vertreter: **Rentzsch, Heinz et al, Honeywell Europe S.A.
Holding KG Kaiserleistrasse 55 Postfach 184,
D-6050 Offenbach am Main (DE)**

## Schaltkreis für ein D-Flip-Flop.

Die vorliegende Erfindung bezieht sich auf einen Schaltkreis für ein D-Flip-Flop nach dem Gattungsbegriff des Anspruches 1, wie er auch als Verzögerungs-Flip-Flop im Stand der Technik bekannt ist. Bei derartigen Flip-Flops kann ein falsches Schaltverhalten auftreten, wenn beispielsweise eine Leitungsverbindung zwischen bestimmten NAND-Gattern unterbrochen wird.

Es ist daher die Aufgabe der vorliegenden Erfindung, einen Flip-Flop-Schaltkreis der eingangs genannten Art so auszubilden, dass bei einer bestimmten Leitungsunterbrechung ein fehlerhaftes Ausgangssignal nicht auftreten kann. Die Lösung dieser Aufgabe gelingt gemäss der im Anspruch 1 gekennzeichneten Erfindung.

Während das bekannte D-Flip-Flop die Umschaltung des Eingangssignales noch nachvollzieht und dann aber bei einer Leitungsunterbrechung den Umschaltzustand unabhängig von dem Verlauf des Eingangssignales beibehält, führt das verbesserte erfindungsgemässe D-Flip-Flop bei der gleichen Leitungsunterbrechung überhaupt keine Umschaltung in Abhängigkeit von der Umschaltung des Eingangssignales aus. Vielmehr wird auf Grund einer durch das Verzögerungsglied hervorgerufenen Eigenprüfung des Flip-Flops das Ausgangssignal vor einer Änderung des Eingangssignales bereits auf einem konstanten, die Fehlfunktion des Flip-Flops anzeigenden Pegel gehalten.

Anhand eines in den Figuren der beiliegenden Zeichnungen dargestellten Ausführungsbeispieles sei zunächst das bekannte D-Flip-Flop und sodann das verbesserte D-Flip-Flop in Aufbau und Wirkungsweise beschrieben. Es zeigen:

Fig. 1 einen herkömmlichen D-Flip-Flop-Schaltkreis;

Fig. 2A und 2B Taktdiagramme zur Erläuterung der fehlerfreien und der fehlerhaften Funktion des Schaltkreises gemäss Fig. 1;

Fig. 3 einen D-Flip-Flop-Schaltkreis gemäss der Erfindung, und

Fig. 4A und 4B Taktdiagramme zur Erläuterung der Funktionsweise des erfindungsgemässen Flip-Flops.

Das bekannte D-Flip-Flop besteht aus 4 NAND-Gatter Q1 bis Q4. Dem ersten NAND-Gatter werden gleichzeitig ein Eingangssignal E und ein Taktsignal C zugeführt. Das zweite NAND-Gatter Q2 wird von dem Ausgangssignal AQ1 des ersten NAND-Gatters Q1 und von dem Taktsignal C beaufschlagt.

Die dritten und vierten NAND-Gatter Q3 und Q4 sind über Kreuz gekoppelt und bilden ein asynchrones RS-Flip-Flop, dem die Ausgangssignale AQ1 und AQ2 der ersten und zweiten NAND-Gatter Q1 und Q2 als Setz- bzw. Rückstellsignale zugeführt werden. Das Ausgangssignal A des D-Flip-Flops nimmt einen Anfangswert ein, der über ein einem weiteren Setzeingang zugeführtes Triggersignal Tr vorgegeben wird.

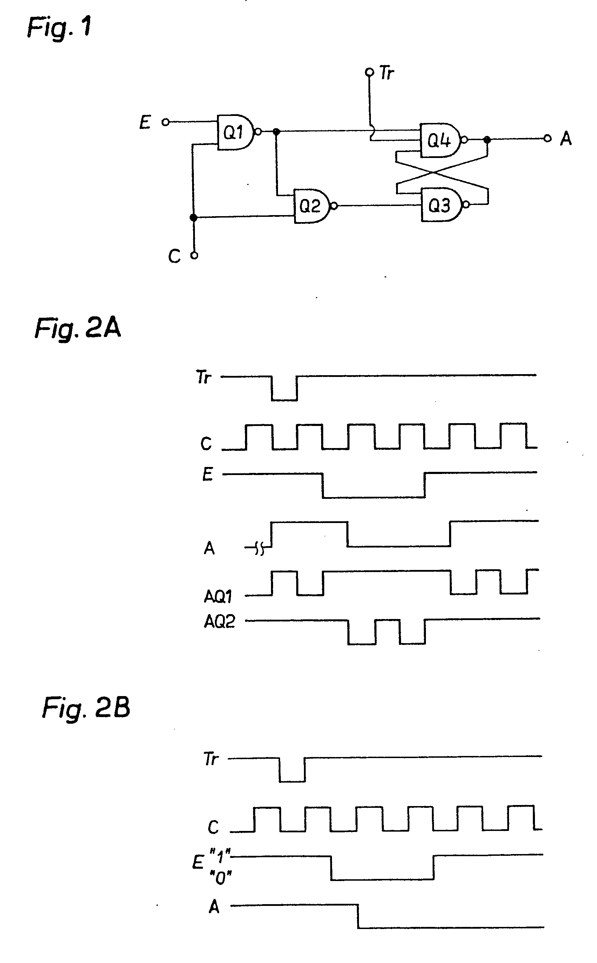

Die Funktion dieses Flip-Flops ergibt sich aus dem Taktdiagramm gemäss Fig. 2A. Das Flip-Flop wird zunächst durch das anfänglich zugeführte Triggersignal Tr gesetzt und das Setzen und die Rückstellung des Flip-Flops wiederholt sich beim Empfang des Eingangssignales E und des Taktsignales C, so dass sich ein Ausgangssignal A in bekannter Weise ergibt, wie es durch den Kurvenzug A in Fig. 2A dargestellt ist. Dieses Ausgangssignal A stellt eine Verschiebung des Eingangssignales dar.

Nimmt man bezüglich dieses bekannten D-Flip-Flops an, dass auf Grund eines fehlerhaften Zustandes; beispielsweise auf Grund eines durchgebrannten Drahtes, das Ausgangssignal des ersten NAND-Gatters Q1 nicht dem vierten NAND-Gatter Q4 zugeführt wird, so ergibt sich eine Funktionsweise des D-Flip-Flops, wie sie aus Fig. 2B ersichtlich ist. Wie der Fachmann leicht erkennt, schaltet zwar das Ausgangssignal A von dem Wert 1 auf den Wert 0 um, nachdem das Eingangssignal E zuvor von dem Wert 1 auf den Wert 0 umgeschaltet hat; das Ausgangssignal A behält jedoch diesen 0-Zustand unabhängig von dem Zustand des Eingangssignales E bei.

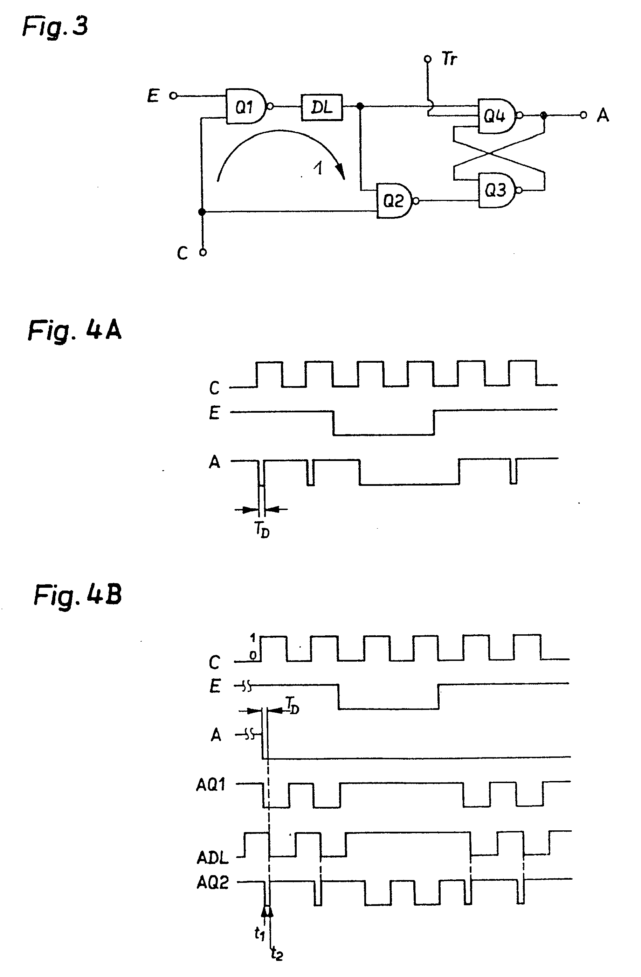

Wie man aus der nachstehenden Beschreibung der Fig. 3 und 4 erkennen wird, wird durch den erfindungsgemässen Schaltkreis ein derart fehlerhafter Zustand des D-Flip-Flops bereits im voraus festgestellt.

Gemäss Fig. 3 ist in den ansonsten mit dem Schaltkreis gemäss Fig. 1 übereinstimmenden Schaltkreis zwischen den Ausgang des ersten NAND-Gatters Q1 und den einen Eingang des zweiten NAND-Gatters Q2 ein Verzögerungsglied DL geschaltet. Die Verzögerungszeit $T_D$ des Verzögerungsgliedes DL wird hinreichend gross gewählt, um das Ausgangssignal A des nachgeschalteten RS-Flip-Flops durch einen kurzen Impuls umzukehren, der auf Grund des Verzögerungsschaltkreises DL am Ausgang des zweiten NAND-Gatters Q2 erhalten wird. Der Verzögerungsschaltkreis DL kann aus einer bestimmten Anzahl von in Reihe geschalteten Invertern bestehen, wobei die den Invertern anhaftende Verzögerungszeit benutzt wird, um die gewünschte Verzögerung zu erzielen.

Bei einer durch das Verzögerungsglied DL vorgegebenen Verzögerungszeit $T_D$ ergibt sich gemäss Fig. 4A auf Grund eines vorliegenden Eingangssignales E das um die Verzögerungszeit des Flip-Flops verschobene Ausgangssignal A. Während das hierzu erforderliche Taktsignal C dargestellt ist, wurde auf die Darstellung des dem zusätzlichen Setzeingang zugeführten Triggersignales Tr verzichtet. Es liegt auf der Hand, dass die Verzögerungszeit des Verzögerungsgliedes kleiner als die Verzögerungszeit des D-Flip-Flops sein muss.

In dem Fall, wo auf Grund eines Fehlers das Ausgangssignal des ersten NAND-Gatters Q1 nicht zu dem Eingang des vierten NAND-Gatters Q4 übertragen wird, wird das Ausgangssignal A des RS-Flip-Flops, das den 1-Pegel einnimmt, wenn dem Setzeingang der 0-Pegel zugeführt wird, in einem 0-Pegel invertiert, da das zweite NAND-Gatter Q2 in diesem Fall ein 0-Signal sofort an seinem Ausgang ausgibt. Da anschliessend das Ausgangssignal des ersten NAND-Gatters Q1 nicht dem Setzeingang zugeführt wird, behält das Ausgangssignal A des Flip-Flops den 0-Pegel bei. Es wird daher gemäss Fig. 4B am Ausgang des Flip-Flops der Impulszug A ausgegeben, wobei man erkennt, dass der Ausgang A zwangsweise auf den Wert 0 gesetzt wird, bevor die Zuführung des Eingangssignales eine fehlerhafte Verschiebefunktion des Flip-Flops auslösen kann.

Das anfänglich auf den Wert 1 gesetzte Ausgangssignal A wird unmittelbar über den Setzeingang auf den Wert 0 umgeschaltet und dieser Zustand des Ausgangssignales A wird beibehalten, so dass eine Bedienungsperson den fehlerhaften Zustand feststellen kann. Auf diese Weise wird ein fehlerhafter Betrieb einer Einrichtung vermieden, die an den Ausgang des D-Flip-Flops angeschlossen ist.

Bei dem vorstehend beschriebenen Ausführungsbeispiel ist das Verzögerungsglied DL am Ausgang des ersten NAND-Gatters Q1 vorgesehen. Dies stellt jedoch nicht den einzig möglichen Ort der Anordnung für das Verzögerungsglied DL dar; vielmehr kann das Verzögerungsglied DL in dem dargestellten Pfad 1 gemäss Fig. 3 an irgendeiner Stelle angeordnet werden. Mit dieser Anordnung kann das Flip-Flop seine Funktion selbst überprüfen.

## Patentansprüche

1. Schaltkreis für ein D-Flip-Flop mit einem ersten von einem Eingangssignal (E) und einem Taktsignal (C) beaufschlagten NAND-Gatter (Q1), einem zweiten von dem Ausgangsignal (AQ1) des ersten NAND-Gatters (Q1) und dem Taktsignal (C) beaufschlagten NAND-Gatter (Q2) und mit über Kreuz gekoppelten dritten und vierten NAND-Gattern (Q3 und Q4), denen die Ausgangssignale der ersten und zweiten NAND-Gatter (Q1 und Q2) als Setz- bzw. Rückstellsignale zugeführt werden, wobei deren anfängliches Ausgangssignal (A) über einen weiteren Eingang (Tr) vorgebbar ist, gekennzeichnet durch die Anordnung eines Verzögerungsgliedes (DL) zwischen dem Ausgang des ersten NAND-Gatters (Q1) und dem von dem Ausgangssignal des ersten NAND-Gatters (Q1) beaufschlagten Eingang des zweiten NAND-Gatters (Q2) oder vor dem Takteingang des ersten NAND-Gatters (Q1), wobei die Verzögerungszeit ($T_D$) des Verzögerungsgliedes (DL) kleiner als die Verzögerungszeit des Flip-Flops bemessen ist.

2. Schaltkreis nach Anspruch 1, dadurch gekennzeichnet, dass mehrere in Reihe geschaltete Inverter das Verzögerungsglied (DL) bilden.

## Revendications

1. Circuit de commande pour une bascule D comprenant une première porte NON-ET (Q1) recevant un signal d'entrée (E) et un signal d'horloge (C), une seconde porte NON-ET (Q2) recevant le signal de sortie (AQ1) de la première porte NON-ET (Q1) et le signal d'horloge (C) ainsi qu'une troisième et une quatrième porte NON-ET (Q3 et Q4) couplées en croix, et dont les signaux de sortie (AQ1) sont appliqués à la première et à la seconde porte NON-ET (Q1, Q2) comme des signaux de mise à un ou de remise à zéro, le signal de sortie (A) initial pouvant être obtenu par l'intermédiaire d'une autre entrée (Tr), caractérisé en ce qu'il est prévu un organe de retardement (DL) entre la sortie de la première porte NON-ET (Q1) et l'entrée de la seconde porte NON-ET (Q2) qui est sollicitée par le signal de sortie de la première porte NON-ET (Q1) ou bien avant l'entrée d'horloge de la première porte NON-ET (Q1), le temps de retardement ($T_D$) de l'organe de retardement (DL) étant inférieur au temps de retardement de la bascule.

2. Circuit de commande selon la revendication 1, caractérisé en ce que plusieurs inverseurs branchés en série constituent l'organe de retardement (DL).

## Claims

1. Circuit for a D-flip-flop comprising a first NAND gate (Q1) fed by an input signal (E) and a clock signal (C), a second NAND gate (Q2) fed by the output signal (AQ1) of the first NAND gate (Q1) and the clock signal (C), and cross-coupled third and fourth NAND gates (Q3 and Q4) to which the output signals of the first and second NAND gates (Q1 and Q2) are applied as set and reset signals with the initial output signal (A) being determined by a further input (Tr), characterized by the arrangement of a delay circuit (DL) between the output of the first NAND gate (Q1) and the input of the second NAND gate (Q2) being fed by the output signal of the first NAND gate (Q1) or in front of the clock input of the first NAND gate (Q1) with the delay time ($T_D$) of the delay circuit (DL) being smaller than the delay time of the flip-flop.

2. Circuit according to claim 1, characterized in that a plurality of series coupled inverters present the delay circuit (DL).

*Fig. 1*

*Fig. 2A*

*Fig. 2B*

5

*Fig. 3*

*Fig. 4A*

*Fig. 4B*